# FASCICULE DE BREVET EUROPEEN

(11) **EP 2 940 800 B1**
(45) Date de publication et mention de la délivrance du brevet: **09.10.2019**
(21) Numéro de dépôt: 15164476.2
(22) Date de dépôt: 21.04.2015
(51) Int. Cl.: H01R 12/58, H01R 13/73, H01R 12/52, H01R 13/22, H05K 3/36, H01R 12/91, H01R 12/71, H01R 12/70

(54) **ORGANE DE CONNEXION ELECTRIQUE ENTRE DEUX CARTES ELECTRONIQUES ET PROCÉDÉ DE CONNEXION ASSOCIÉ**
ELEKTRISCHE ANSCHLUSSVORRICHTUNG ZWISCHEN ZWEI ELEKTRONISCHEN KARTEN UND DEREN VERBINDUNGSVERFAHREN
ELECTRICAL CONNECTION UNIT BETWEEN TWO ELECTRONIC BOARDS AND CONNECTION METHOD THEREOF

(30) Priorité: 29.04.2014 FR 1453886
(43) Date de publication de la demande: 04.11.2015
(73) Titulaire: Valeo Systemes de Controle Moteur, 95892 Cergy Pontoise Cedex (FR)
(72) Inventeur: Schwartz, Christian, 78400 CHATOU (FR)
(74) Mandataire: Argyma

(56) Documents cités:
- EP-A1- 0 582 264
- EP-A2- 2 685 566
- US-A1- 2014 030 915

## Description

La présente invention concerne un organe de connexion électrique entre deux cartes électroniques et un procédé de connexion associé. L'invention concerne aussi un module électronique comprenant un organe de connexion électrique selon l'invention.

On connait un onduleur pour commander une machine électrique embarquée dans un véhicule. Un tel onduleur peut comprendre un module électronique ayant un boîtier ; une carte de puissance comprenant des composants par lesquels passe l'énergie alimentant la machine électrique ; et une carte de commande comprenant des composants pour contrôler les composants de la carte de puissance.

Les deux cartes peuvent être positionnées en vis-à-vis l'une de l'autre avec une liaison électrique entre elles deux. Notamment, une première carte est positionnée dans un fond du boîtier ; la deuxième carte est positionnée au dessus de la première carte en reposant sur un muret du boîtier. La liaison électrique entre les deux cartes peut être réalisée par des broches de connexion électrique ayant chaque extrémité brasée sur une carte. Cependant, le module électronique peut subir des vibrations, du fait du fonctionnement de la machine électrique ou de son application dans un environnement automobile. Ces vibrations peuvent fragiliser les brasures entre les broches et les cartes. Une solution consiste à fixer la carte de puissance sur un fond du boîtier et maintenir la carte de contrôle pour limiter ses vibrations, et ainsi éviter que des vibrations accélèrent l'usure des brasures. Cependant, prévoir la connexion électrique et le maintien des cartes peut donner lieu à plusieurs étapes qui complexifient la fabrication du module électronique.

Le document EP2685566A2 décrit un connecteur électrique entre deux cartes. Ce connecteur ne permet pas un maintien limitant les vibrations.

Il se pose donc le problème d'obtenir de façon simple une connexion électrique entre deux cartes qui soit résistante aux vibrations.

Afin de résoudre ce problème, l'invention concerne un organe de connexion électrique destiné à connecter électriquement deux cartes électroniques entre elles, tel que revendiqué dans la revendication 1, l'organe de connexion comprenant :
- au moins une broche électrique destinée à connecter électriquement les deux cartes entre elles,
- une pièce de liaison mécanique pour lier mécaniquement les deux cartes entre elles,
l'organe de connexion électrique étant agencé pour permettre de manière concomitante la connexion électrique par la broche, et la liaison mécanique par la pièce de liaison, des deux cartes.

Dans le cadre de la présente demande, on entend par carte électronique, un support, telle qu'une plaque, permettant de maintenir et de relier électriquement un ensemble de composants électroniques entre eux, dans le but de réaliser une fonction électronique, en particulier une fonction électronique complexe.

En liant mécaniquement les deux cartes entre elles, une reprise d'effort entre les deux cartes est obtenue. Ainsi, les mouvements relatifs entre les cartes sont limités, voire sensiblement diminués. La broche électrique ne subit plus de vibrations susceptibles d'abimer la connexion électrique entre la broche et les cartes.

Selon l'invention, l'organe de connexion est agencé de façon à assurer de manière concomitante :
- la connexion électrique entre les deux cartes par la broche ; et
- la liaison mécanique entre les deux cartes par la pièce de liaison.

Grâce à l'invention, en positionnant l'organe de connexion électrique sur les deux cartes, on positionne en même temps le conducteur électrique pour la connexion électrique entre les deux cartes et la pièce de liaison pour la liaison mécanique entre les cartes. Le montage des deux cartes ensemble, ou dans un module les comprenant, en est simplifié.

Selon l'invention, l'organe comporte un corps qui porte à la fois la broche électrique et ladite pièce de liaison mécanique. Notamment, le corps porte uniquement la ou les broches électriques et la pièce de liaison mécanique.

Le fait de mettre la broche et la pièce de liaison sur un corps commun permet de simplifier les opérations de connexion électrique et de liaison mécanique entre les deux cartes car les éléments de connexion électrique et de liaison mécanique sont manipulables ensemble de manière aisée.

En particulier, une portion du corps qui maintient ensemble la broche et la pièce de liaison mécanique, voire le corps dans son intégralité, peut être d'un seul tenant.

En prenant en main le corps, un opérateur peut donc positionner en une seule fois la broche électrique et la pièce de liaison mécanique sur les deux cartes pour obtenir une connexion électrique et une liaison mécanique entre les cartes.

Le corps est par exemple en un matériau isolant électriquement.

Selon une variante, ledit corps comprend une portion, dite portion d'appui, destinée à recevoir en appui une des cartes électroniques. En particulier, la portion d'appui et la pièce de liaison du corps sont agencées de sorte que la carte électronique soit maintenue en place en étant coincée entre la portion d'appui du corps et un point par lequel la pièce de liaison mécanique est solidaire de la carte. Ainsi, le maintien de la carte électronique est amélioré.

Selon une variante particulière, la broche électrique et la pièce de liaison s'étendent suivant une même direction longitudinale. En particulier, la portion d'appui du corps s'étend transversalement à la dite direction.

Selon une variante particulière, la portion d'appui du corps comprend des renflements, en particulier des picots, destinés à recevoir la carte en appui. Ces renflements permettent de laisser un espace entre la surface de la carte qui est en vis-à-vis de la portion d'appui et la surface de la portion d'appui qui est entre les renflements. Ceci est particulièrement avantageux quand la connexion électrique ou la liaison mécanique avec la carte est réalisée par brasage. Grâce à l'espace aménagé par les renflements entre la carte et le reste de la portion d'appui du corps, un ménisque peut se former durant le brasage de part et d'autre de la carte sans le risque d'une diffusion de la matière du ménisque sur la portion d'appui. Ainsi, l'occurrence d'une fuite électrique est évitée.

Selon un mode de réalisation, la pièce de liaison est en forme de lame.

Selon un mode de réalisation, la pièce de liaison comprend deux extrémités, chaque extrémité étant destinée à être liée mécaniquement avec une des deux cartes.

Selon un mode de réalisation, la pièce de liaison est destinée à être liée mécaniquement à une des cartes par brasage. En particulier, la pièce de liaison est destinée à être brasée avec une piste électrique de la carte électronique ; ou avec une pièce métallique rapportée sur la carte électronique pour ce brasage. En particulier cette pièce métallique n'a pas de fonction électrique et sert uniquement au brasage de la pièce de liaison avec la carte.

Selon l'invention, la pièce de liaison est destinée à être liée mécaniquement à au moins une des cartes par vrillage d'une extrémité de la pièce de liaison dans une ouverture de la carte. En particulier, l'extrémité est destinée à venir en prise contre un bord de ladite ouverture pour être maintenue dans l'ouverture. Plus particulièrement, la pièce de liaison est suffisamment souple pour que son extrémité puisse être tournée sur elle-même autour de son axe longitudinal.

Selon un mode de réalisation, la broche électrique a une extrémité comportant un pied flexible, en particulier en forme de S, destiné à venir contre la surface d'une des cartes. Grâce au pied flexible, la broche peut supporter des incertitudes dans le montage de l'organe avec les deux cartes.

Selon un mode de réalisation, l'organe comprend une pluralité de broches. Les broches peuvent être organisées en deux rangées, qui en particulier s'étendent parallèlement l'une par rapport à l'autre. En outre, les broches peuvent être réparties de part et d'autre de la pièce de liaison.

Selon un mode de réalisation, ladite pièce de liaison et la broche s'étendent longitudinalement suivant une direction.

Selon un mode de réalisation, ledit corps comprend deux parties s'étendant principalement dans une direction qui est transverse à ladite direction longitudinale de la broche et de la pièce de liaison, les dites parties étant telles que :
- une première partie maintient la broche et la pièce de liaison au niveau d'une première région de la broche et de la pièce de liaison ;
- une deuxième partie maintient la broche et la pièce de liaison au niveau d'une deuxième région de la broche et de la pièce de liaison ;
les deux parties étant distantes l'une de l'autre suivant la direction longitudinale.

Selon une variante, une desdites parties du corps correspond à la dite portion d'appui destinée à recevoir en appui une des cartes électroniques.

Selon une variante, le corps comprend au moins une partie longitudinale reliant les première et deuxième parties du corps.

L'invention concerne également un organe de connexion électrique destiné à connecter électriquement deux cartes électroniques entre elles, l'organe de connexion comprenant :
- au moins une broche électrique destinée à connecter électriquement les deux cartes entre elles,
- une pièce de liaison mécanique pour lier mécaniquement les deux cartes entre elles, l'organe de connexion électrique étant agencé pour permettre de manière concomitante la connexion électrique par la broche, et la liaison mécanique par la pièce de liaison, des deux cartes,
- un corps qui porte à la fois ladite broche électrique et ladite pièce de liaison mécanique, ledit corps comprenant une portion, dite portion d'appui, destinée à recevoir en appui une des cartes électroniques, la portion d'appui et la pièce de liaison étant agencées de sorte que ladite carte électronique soit maintenue en place en étant coincée entre la portion d'appui et un point par lequel la pièce de liaison mécanique est solidaire de la carte.

L'organe de connexion peut comprendre l'une ou plusieurs des caractéristiques décrites précédemment.

L'invention concerne en outre un module électronique comprenant :
- deux cartes électroniques ;
- un organe de connexion électrique selon l'invention qui connecte électriquement et lie mécaniquement de façon concomitante les deux cartes.

Selon un mode de réalisation, la pièce de liaison est liée mécaniquement à l'une des cartes par une brasure. En particulier, la pièce de liaison est brasée avec une piste électrique de la carte électronique ; ou avec une pièce métallique rapportée sur la carte électronique pour ce brasage. En particulier, cette pièce métallique sert uniquement au brasage de la pièce de liaison avec la carte. Alternativement, cette pièce métallique a une fonction électrique, notamment en servant de liaison avec la masse électrique du module électronique.

Selon l'invention, la pièce de liaison est liée mécaniquement à au moins l'une des cartes par une déformation d'une de ses extrémités dans une ouverture de la carte. L'extrémité est vrillée dans l'ouverture de la carte. En particulier, l'extrémité déformée de la pièce de liaison vient en prise contre un bord de ladite ouverture pour être maintenue dans l'ouverture. La pièce de liaison peut être liée avec une pièce rapportée sur la carte électronique pour cette liaison mécanique. En particulier, cette pièce rapportée sert uniquement à la liaison mécanique de la pièce de liaison avec la carte. Alternativement, cette pièce rapportée a une fonction électrique, notamment en servant de liaison avec la masse électrique du module électronique.

A cet effet, l'ouverture peut présenter un grand diamètre et un petit diamètre. La liaison mécanique peut être obtenue en introduisant la pièce de liaison dans l'ouverture de la carte avec sa dimension transversale la plus grande parallèle au grand diamètre du trou. Ensuite, la pièce de liaison peut être vrillée pour avoir sa dimension transversale la plus grande venir vers la direction du petit diamètre du trou. Ainsi, la pièce de liaison vient contre les bords du trou pour rester en prise dans celui-ci.

Selon un mode de réalisation, une première carte repose sur un support, la liaison mécanique entre la pièce de liaison et la deuxième carte comprenant une mise en appui de la deuxième carte sur une portion, dite portion d'appui, dudit support.

En particulier, la portion d'appui du support et la pièce de liaison sont agencées de sorte que la deuxième carte électronique soit maintenue en place en étant coincée entre la portion d'appui du support et un point par lequel la pièce de liaison mécanique est solidaire de la carte. Ainsi, le maintien de la deuxième carte électronique dans le module est amélioré. Les vibrations de la deuxième carte sont réduites.

L'invention concerne aussi un procédé de connexion électrique de deux cartes électroniques entre elles, tel que revendiqué dans la revendication 11, comprenant les étapes consistant à :
- positionner un organe de connexion électrique selon l'invention ;
- monter la deuxième carte sur l'organe électrique, la broche de l'organe électrique réalisant une connexion électrique entre la première et la deuxième carte, et la pièce de liaison de l'organe électrique réalisant une liaison mécanique entre les cartes, de façon concomitante.

L'invention sera mieux comprise en faisant référence aux dessins, dans lesquels :
- la figure 1 illustre un exemple d'organe de connexion électrique selon l'invention ;
- la figure 2 représente une autre vue de l'organe de connexion illustré en figure 1 ;
- la figure 3 représente une vue de profil de l'organe de connexion illustré en figure 1 ;
- la figures 4 à 6 illustrent des étapes d'assemblage d'un exemple d'organe de connexion électrique selon l'invention avec deux cartes.

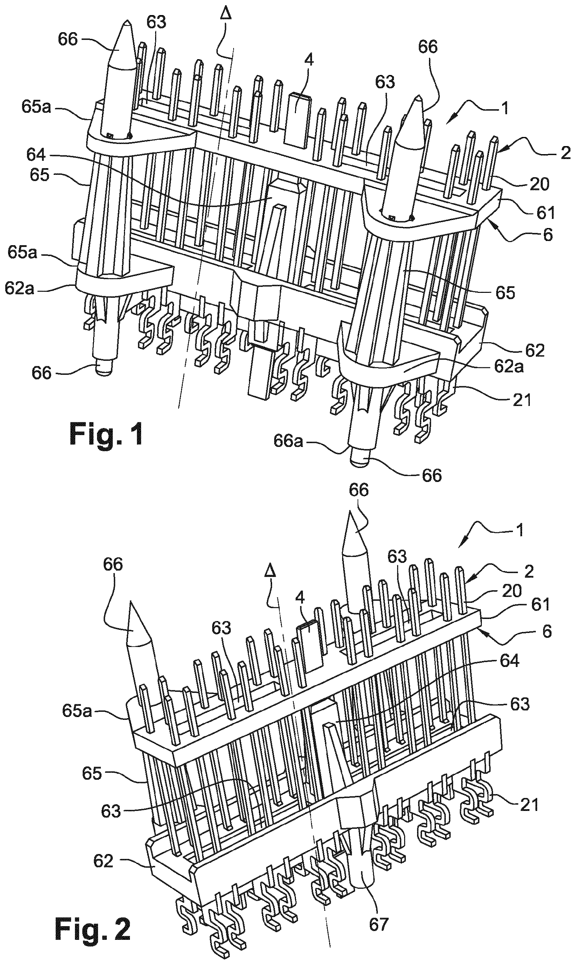

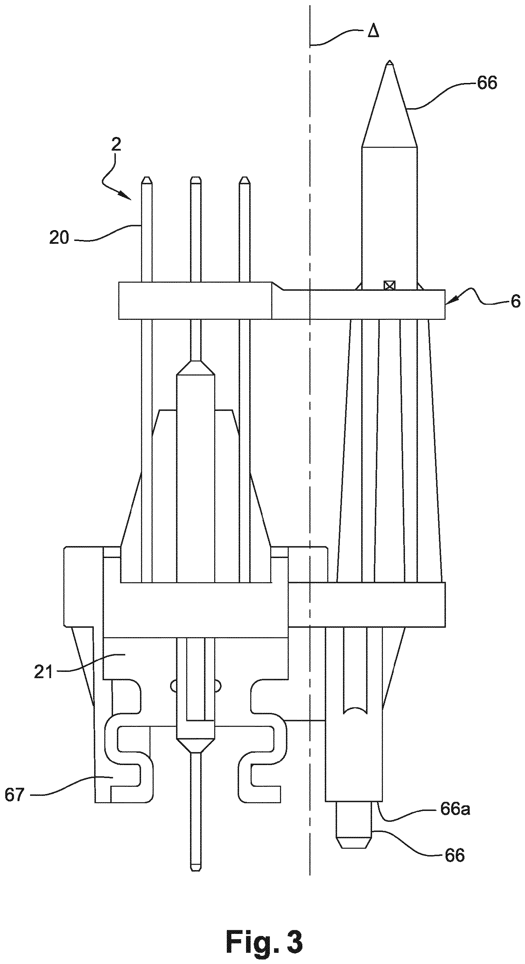

Un exemple d'organe de connexion électrique selon l'invention, qui est destiné à connecter électriquement deux cartes électroniques, va être présenté en faisant référence aux figures 1 à 3.

L'organe de connexion électrique 1 comprend plusieurs broches électriques 2 qui sont destinées à connecter électriquement les deux cartes entre elles. Chaque broche 2 s'étend suivant une direction longitudinale Δ. La broche 2 comprend notamment une portion 20 en forme de tige et un pied flexible 21. Dans l'exemple considéré le pied flexible 21 a sensiblement une forme en S.

Une pièce de liaison 4 sert à relier mécaniquement les deux cartes entre elles. La pièce de liaison 4 est en forme de lame et, par exemple, s'étend longitudinalement suivant la même direction Δ que les broches 2. De préférence, les broches 2 et la pièce de liaison 4 sont en des matériaux ayant des coefficients de dilation thermique sensiblement égaux. Par exemple, les broches 2 et la pièce de liaison 4 sont en bronze, laiton, cuivre, ou en un alliage cuivre-fer.

Un corps 6 porte à la fois les broches électriques 2 et la pièce de liaison mécanique 4. Le corps 6 maintient ensemble les broches 2 et la pièce de liaison 4. Ainsi, les broches 2, la pièce de liaison 4 et le corps 6 forment un seul élément qui peut être manipulé dans son ensemble pour être positionné respectivement aux deux cartes. Le corps 6 est en plastique, de préférence il est en un plastique qui supporte un passage dans un four à refusion. L'organe de connexion 1 comprend uniquement les broches 2, la pièce de liaison 4 et le corps 6.

Le corps 6 comprend une première et une deuxième partie 61, 62 qui s'étendent principalement dans une direction transverse à la direction longitudinale Δ des broches 2 et de la pièce de liaison 4. En particulier, ces première et deuxième parties 61, 62 peuvent avoir des formes sensiblement parallélépipédiques. La première partie 61 maintient les broches 2 et la pièce de liaison 4 au niveau d'une première région de celles-ci, et la seconde partie 62 les maintient au niveau d'une deuxième région, les première et deuxième régions étant distantes l'une de l'autre suivant la direction longitudinale Δ. Ces deux régions sont de préférence chacune à proximité d'une extrémité respective des broches 2 et de la pièce de liaison 4. Ainsi, la quantité de matière utilisée pour le corps 6 est limitée, tout en permettant un maintien en position des broches 2 et de la pièce de liaison 4 les uns par rapport aux autres.

La deuxième partie 62 est notamment au niveau de la séparation entre le pied flexible 21 d'une broche et le reste de la broche 2. Plus particulièrement, la tige 20 a une largeur plus étroite que le pied flexible 21. Les trous du corps 6 par lesquels passe la broche 2 étant adaptés à la largeur de la tige 20, le pied flexible 21 ne peut traverser le corps 6. Ceci contribue au maintien de la broche 2 dans le corps 6. Des irrégularités en surface de la broche 2 qui correspondent avec des irrégularités sur les parois internes de ces trous du corps 6 peuvent encore améliorer le maintien de la broche 2 dans le corps 6, en évitant que l'un glisse par rapport à l'autre.

Pour limiter encore plus la quantité de matière utilisée pour le corps 6, chaque partie 61, 62 du corps 6 peut comprendre des évidements 63 dans une zone qui est libre des broches 2 et de la pièce de liaison 4.

Le corps 6 peut comprendre, en outre, un fourreau 64 qui s'étend depuis la première 61 ou la deuxième 62 partie pour recouvrir une étendue de la pièce de liaison 4 située entre les première et deuxième parties 61, 62. Ce fourreau 64 permet d'améliorer la rigidité de la pièce de liaison 4 de façon à limiter les vibrations auxquelles elle pourrait être sujette lors d'une utilisation d'un ensemble comprenant les deux cartes munis de l'organe de connexion électrique 1. Des nervures peuvent courir le long du fourreau 64 depuis la première partie 61 ou la deuxième 62 du corps 6 pour contribuer à la rigidité de la pièce de liaison 4.

Le corps 6 comprend une ou plusieurs parties 65, dites parties longitudinales, qui relient les première et seconde parties transverses 61, 62 du corps 6. La partie longitudinale 65 s'étend principalement suivant la direction longitudinale Δ des broches 2 et de la pièce de liaison 4. De préférence, la partie longitudinale 65 est solidaire de la première partie 61 et de la deuxième partie 62 au niveau d'une périphérie de celles-ci. Dans l'exemple illustré en figures 1 à 3, plusieurs parties longitudinales 65 sont solidaires des parties transverses 61, 62 au niveau de la périphérie des parties 61,62 de forme parallélépipédique.

Plus particulièrement, pour chaque partie longitudinale 65, un décrochement 65a part de la périphérie de la première ou de la deuxième partie 61, 62.

La partie longitudinale 65 comprend une tige qui s'étend du décrochement 65a de la deuxième partie transverse 62 vers le décrochement 65a de la première partie transverse 61. La tige de la partie transverse 65 est intégrale avec le décrochement de la deuxième partie 62 et vient en prise dans un trou traversant du décrochement 65a de la première partie 61. Alternativement, la tige aurait pu être intégrale avec les deux décrochements 65a, ou aurait pu venir en prise dans un trou dans chaque décrochement 65a. La tige de la partie transverse 65a peut être rendue intégrale avec les décrochements 65a par d'autres moyens équivalents.

Le corps 6 comprend des pions de guidage 66 qui vont s'insérer dans des trous correspondants des cartes pour aider l'agencement de l'organe de connexion électrique 1 avec les cartes électroniques. Ces pions de guidage 66 sont portés par les décrochements 65a. En particulier, un pion de guidage 66 peut être un prolongement de la tige d'une partie longitudinale 65.

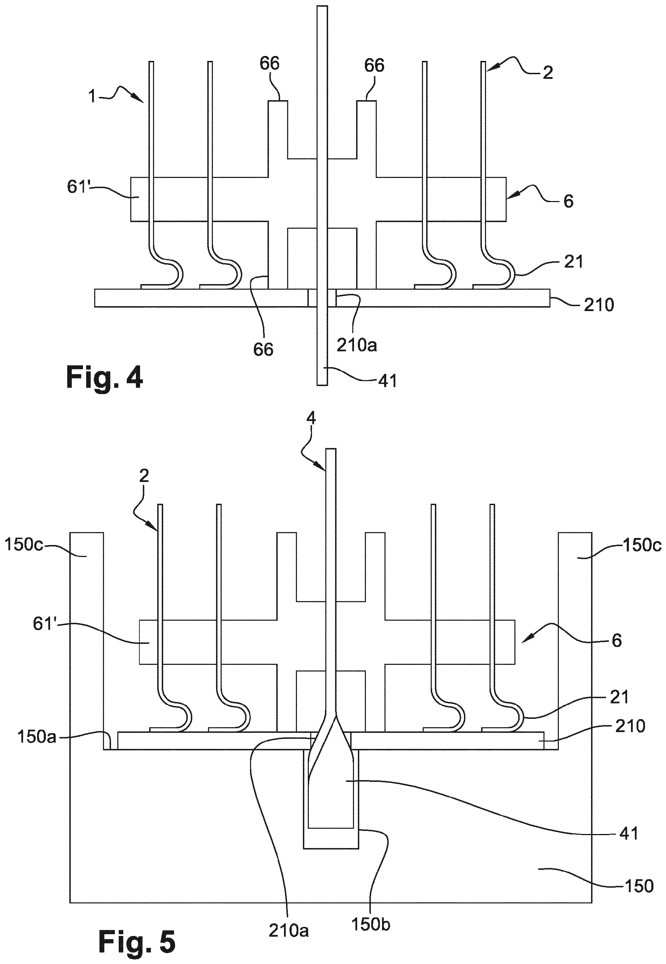

L'assemblage d'un exemple d'organe de connexion électrique avec deux cartes va être expliqué en faisant référence aux figures 4 à 6.

Les figures 4 à 6 représentent une vue en coupe d'un autre exemple d'organe électrique 1 dans lequel le corps 6 maintient les broches 2 et la pièce de liaison 4 par une seule partie transverse 61'. La partie transverse 61' maintient les broches 2 et la pièce de liaison 4 dans des zones médianes de celles-ci, c'est-à-dire des zones situées entre leurs extrémités. En outre, les pieds flexibles 21 des broches 2 ont une forme arrondie qui a sensiblement la forme, en vue de coupe, d'un unique arc de cercle. Comme dans l'exemple illustré en figures 1 à 3, le corps 6 comprend des pions 66 pour le positionnement relatif de l'organe de connexion électrique 1 avec les cartes électroniques.

En figure 4, l'organe de connexion 1 est positionné sur une première carte 210. Les pieds flexibles 21 viennent contre une première surface de la carte 210 pour être brasés avec elle. A cet effet, le positionnement de l'organe de connexion 1 peut être précédé du dépôt sur la carte 210 d'un matériau aux emplacements où seront situés les pieds flexibles 21 afin de former des brasures ultérieurement. La pièce de liaison 4 a une extrémité 41 qui passe dans une ouverture 210a de la première carte 210 pour dépasser d'une deuxième surface de la carte 210 qui est opposée à la première surface.

Comme illustré en figure 5, l'extrémité 41 de la pièce de liaison 4 qui dépasse de la deuxième surface de la première carte 210 est vrillée de façon à venir contre un bord de l'ouverture 210a de la première carte 210 pour être maintenue dans l'ouverture. Ainsi la première carte 210 est maintenue entre les pieds flexibles 21 et le point de liaison mécanique entre la pièce de liaison 4 et la carte 210. L'organe de connexion électrique 1 et la carte 210 sont donc assemblés.

Pour éviter qu'un effort trop important soit exercé sur les pieds flexible 21, on peut prévoir sur les pions 66 un rebord 66a similaire à celui présenté par les pions 66 dans l'exemple illustré en figures 1 à 3. Ces rebords 66 viennent en appui contre la surface de la carte 210. Ainsi, la première carte 210 est principalement maintenue entre les rebords 66a des pions 66 et le point de liaison mécanique entre la pièce de liaison 4 et la carte 210.

En outre, pour améliorer la stabilité de l'organe de connexion électrique 1 sur la première carte 210, le corps 6 peut comprendre une jambe similaire à la jambe 67 de l'exemple illustré en figures 1 à 3. La jambe 67 est positionnée par rapport aux pions 66, destinés à venir dans la première carte 210, de façon à stabiliser le maintien de l'organe de connexion 1 sur la première carte 210. En particulier, la jambe 67 est solidaire de la partie transverse 61', 62 au niveau d'une périphérie de celle-ci. La jambe 67 est positionnée sur un côté qui est opposé au côté par lequel les pions 66 sont solidaires de partie transverse 61', 62. Chaque pied flexible 21 a une surface qui vient en contact avec la première surface de la carte 210. Ces surfaces des pieds flexibles 21 sont sensiblement dans un même plan. La jambe 67 s'étend depuis son point de jonction avec le corps 6 vers ce plan qui comprend sensiblement les surfaces des pieds flexibles 21. La jambe 67 vient donc en appui contre la surface de la première carte 210. Ainsi, En ayant des appuis 66a, 67 sur des côtés opposés de la partie transverse 61', 62, on s'assure que l'organe 1 est bien stabilisé. La stabilité est encore améliorée si la jambe 67 est à équidistance des deux pions 66 de la partie transverse 61', 62.

On effectue ensuite un brasage des pieds flexibles 21 avec la première carte électronique 210. A cet effet, l'ensemble constitué de l'organe de connexion 1 et de la première carte 210 peut être passé dans un four à refusion. Ensuite, cet ensemble est positionné dans un boîtier 150 d'un module électronique. Alternativement, l'ensemble constitué de l'organe de connexion 1 et de la première carte 210 peuvent être d'abord positionnés dans le boîtier 150, puis le tout est passé dans un four à refusion.

La première carte 210 vient reposer sur un fond 150a du boîtier 150. Le fond 150a comprend un trou 150b dans lequel l'extrémité vrillée 41 peut venir se loger. Si bien que la première carte 210peut intégralement reposer sur le reste du fond 150a.

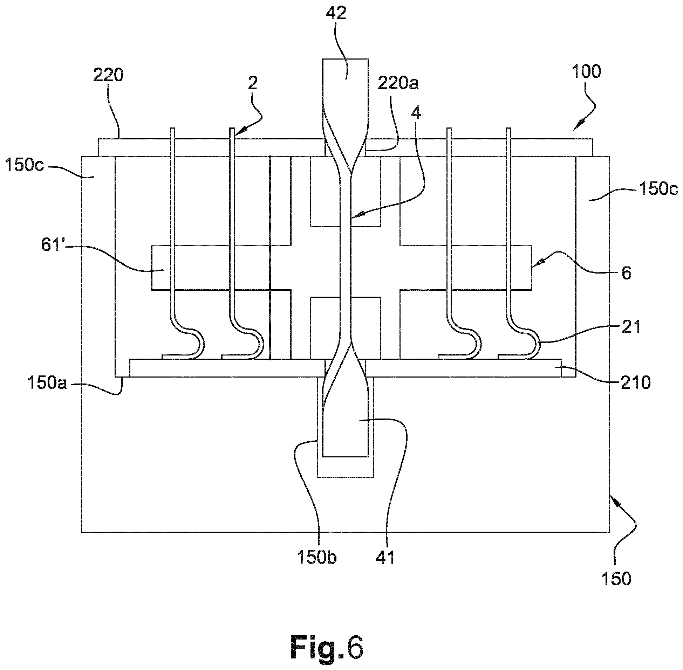

Ensuite, comme illustré en figure 6, la deuxième carte 220 est montée sur l'organe de connexion électrique 1 et vient en appui contre des murets 150c sui s'élèvent depuis le fond 150a du boîtier 150. Les broches 2 passent par des ouvertures correspondantes de la deuxième carte 220. Les pions 66 aident au positionnement relatif de l'organe de connexion 1 et de la deuxième carte 220. Comme pour la première carte 210, la pièce de liaison 4 passe dans une ouverture correspondante 220a de la deuxième carte 220 pour dépasser d'une deuxième surface de la carte 210 qui est opposée à une première surface par laquelle les broches 2 et la pièce de liaison 4 sont introduites dans la deuxième carte 220.

De même que pour la première carte, l'extrémité 42 de la pièce de liaison 4 qui dépasse de la deuxième surface de la deuxième carte 220 est vrillée de façon à venir contre un bord de l'ouverture 220a de la deuxième carte 220 pour être maintenue dans l'ouverture. Ainsi, la deuxième carte 220 est maintenue entre les murets 150a du boîtier 150 et le point de liaison mécanique entre la pièce de liaison 4 et la deuxième carte 220. L'organe de connexion électrique 1 et la deuxième carte 220 sont donc assemblés.

On effectue ensuite un brasage des broches 2 avec la deuxième carte électronique 220. A cet effet, l'ensemble constitué de l'organe de connexion 1, la première carte 210, la deuxième carte 220, et le boîtier 150 peut être passé dans un four à refusion.

On obtient ainsi un module électronique 100, auquel d'autres éléments peuvent être rajoutés pour obtenir une fonctionnalité souhaitée, par exemple une fonctionnalité de convertisseur de tension continu/alternatif ou continu/continu.

L'invention n'est pas limitée aux exemples décrits. En particulier, l'organe de connexion électrique 1 aurait pu comprendre une seule broche électrique 2. Inversement, l'organe de connexion 1 pourrait comprendre plusieurs pièces de liaison 4. La broche 2 pourrait avoir des extrémités différentes. Par exemple, les extrémités pourraient être sensiblement identiques, c'est-à-dire être deux pieds flexibles 21 ou deux extrémités en forme de tige 20. La liaison mécanique entre la pièce de liaison 4 et les cartes 210, 220 auraient pu être obtenus par tout autre moyen de fixation équivalent, par exemple par brasage.

Les exemples d'organe de connexion 1 pourraient comprendre des renflements, en particulier des picots, qui s'étendraient depuis la partie transverse 61, 61'et sur lesquels la deuxième carte 220 peut venir en appui. La partie transverse 61,61' forme alors une portion d'appui pour la deuxième carte. Ainsi, la deuxième carte 220 viendrait en prise entre ces picots et le point de liaison mécanique entre la pièce de liaison 4 et la deuxième carte 220. Si la deuxième carte 220 a une dimension sensiblement égale à une dimension transversale de la portion d'appui 61,61', la deuxième carte 220 peut alors être maintenue par l'organe de connexion électrique 1 sans être en outre en appui sur les murets 150b du boîtier 150.

## Revendications

1. Organe de connexion électrique (1) destiné à connecter électriquement deux cartes électroniques entre elles, l'organe de connexion comprenant :
- au moins une broche électrique (2) destinée à connecter électriquement les deux cartes entre elles,
- une pièce de liaison mécanique (4) pour lier mécaniquement les deux cartes entre elles, l'organe de connexion électrique (1) étant agencé pour permettre de manière concomitante la connexion électrique par la broche (2), et la liaison mécanique par la pièce de liaison (4), des deux cartes,
- un corps (6) qui porte à la fois ladite broche électrique (2) et ladite pièce de liaison mécanique (4), ledit corps (6) comprenant une portion, dite portion d'appui, destinée à recevoir en appui une des cartes électroniques, la portion d'appui et la pièce de liaison (4) étant agencées de sorte que ladite carte électronique soit maintenue en place en étant coincée entre la portion d'appui et un point par lequel la pièce de liaison mécanique (4) est solidaire de la carte,
**caractérisée en ce que** la pièce de liaison (4) est destinée à être liée mécaniquement à au moins une des cartes par l'intermédiaire d'une extrémité vrillée (41, 42) de la pièce de liaison (4) dans une ouverture de la carte.

2. Organe selon la revendication 1, dans lequel ladite portion destinée à recevoir en appui une des cartes comprend des renflements destinés à recevoir la carte en appui.

3. Organe selon la revendication 1 ou 2, dans lequel ladite pièce de liaison (4) est en forme de lame.

4. Organe selon l'une des revendications précédentes, dans lequel la pièce de liaison (4) comprend deux extrémités, chaque extrémité étant destinée à être liée mécaniquement avec une des deux cartes.

5. Organe selon l'une des revendications précédentes, dans lequel la pièce de liaison (4) est destinée à être liée mécaniquement à l'une des cartes par brasage.

6. Organe selon l'une des revendications précédentes, dans lequel la broche électrique (2) a une extrémité comportant un pied flexible (21) destiné à venir contre la surface d'une des cartes.

7. Organe selon l'une des revendications précédentes, dans lequel ladite pièce de liaison (4) et la broche (2) s'étendent longitudinalement suivant une direction (Δ).

8. Organe selon la revendication 7, dans lequel ledit corps (6) comprend deux parties (61, 62) s'étendant principalement dans une direction qui est transverse à la direction longitudinale (Δ) de la broche (2) et de la pièce de liaison (4), les dites parties (61, 62) étant telles que :
- une première partie (61) maintient la broche (2) et la pièce de liaison (4) au niveau d'une première région de la broche (2) et de la pièce de liaison (4) ;
- une deuxième partie (62) maintient la broche (2) et la pièce de liaison (4) au niveau d'une deuxième région de la broche (2) et de la pièce de liaison (4) ;
les deux parties (61, 62) étant distantes l'une de l'autre suivant la direction longitudinale (Δ) de la broche (2) et de la pièce de liaison (4).

9. Organe selon la revendication 8, dans lequel le corps (6) comprend au moins une partie longitudinale (65) reliant les première (61) et deuxième parties (62) du corps (6).

10. Module électronique (100) comprenant :
- deux cartes électroniques (210, 220) ;
- un organe de connexion électrique (1) selon l'une des revendications précédentes qui connecte électriquement et lie mécaniquement de façon concomitante les deux cartes (210, 220), la pièce de liaison (4) étant liée mécaniquement à au moins l'une des cartes (210, 220) par une extrémité (41, 42) vrillée dans une ouverture (210a, 220a) de la carte (210, 220) de façon à venir en prise contre un bord de ladite ouverture (210a, 220a).

11. Module selon la revendication 10, comprenant un organe de connexion électrique (1) selon la revendication 5, dans lequel la pièce de liaison (4) est liée mécaniquement à l'une des cartes (210, 220) par une brasure.

12. Module selon l'une des revendications 10 à 11, dans lequel une première carte (210) repose sur un support (150), la liaison mécanique entre la pièce de liaison mécanique (4) et la deuxième carte (220) comprenant une mise en appui de la deuxième carte (220) sur une portion (150b) dudit support (150).

13. Procédé de connexion électrique de deux cartes électroniques (210, 220) entre elles comprenant les étapes consistant à :
- positionner, sur une première carte (210), un organe de connexion électrique (1) comprenant au moins une broche électrique (2) destinée à connecter électriquement les deux cartes entre elles, une pièce de liaison mécanique (4) pour lier mécaniquement les deux cartes entre elles, l'organe de connexion électrique (1) étant agencé pour permettre de manière concomitante la connexion électrique, par la broche (2), et la liaison mécanique, par la pièce de liaison (4), des deux cartes, l'organe de connexion électrique (1) comprenant aussi un corps (6) qui porte à la fois ladite broche électrique (2) et ladite pièce de liaison mécanique (4), ledit corps (6) comprenant une portion, dite portion d'appui, destinée à recevoir en appui une des cartes électroniques, la portion d'appui et la pièce de liaison (4) étant agencées de sorte que ladite carte électronique soit maintenue en place en étant coincée entre la portion d'appui et un point par lequel la pièce de liaison mécanique (4) est solidaire de la carte, la pièce de liaison (4) étant destinée à être liée mécaniquement à au moins une des cartes par l'intermédiaire d'une extrémité vrillée (41, 42) de la pièce de liaison (4) dans une ouverture de la carte ;
- monter la deuxième carte (220) sur l'organe électrique (1), la broche (2) de l'organe électrique réalisant une connexion électrique entre la première (210) et la deuxième carte (220), et la pièce de liaison (4) de l'organe électrique (1) réalisant une liaison mécanique entre les cartes (210, 220), de façon concomitante.

## Patentansprüche

1. Elektrisches Anschlussorgan (1), das zum elektrischen Anschließen von zwei elektronischen Karten miteinander bestimmt ist, wobei das Anschlussorgan umfasst:
- wenigstens einen elektrischen Stift (2), der zum elektrischen Anschließen der zwei Karten miteinander bestimmt ist;
- ein mechanisches Verbindungsstück (4) zum mechanischen Verbinden der zwei Karten miteinander, wobei das elektrische Verbindungsorgan (1) angeordnet ist, um gleichzeitig den elektrischen Anschluss durch den Stift (2) und die mechanische Verbindung durch das Verbindungsstück (4) der zwei Karten zu erlauben,
- einen Körper (6), der sowohl den genannten elektrischen Stift (2) als auch die genannte mechanische Verbindung (4) trägt, wobei der genannte Körper (6) einen als Stützabschnitt bezeichneten Abschnitt umfasst, der zum aufstützenden Aufnehmen einer der elektronischen Karten bestimmt ist, wobei der Abstützabschnitt und das Verbindungsstück (4) derart angeordnet sind, dass die genannte elektronische Karte an Ort und Stelle festgehalten und dabei zwischen dem Stützabschnitt eingespannt ist, durch den das mechanische Verbindungsstück (4) fest mit der Karte verbunden ist,
**dadurch gekennzeichnet, dass** das Verbindungsstück (4) zum mechanischen Verbinden mit wenigstens einer der Karten mittels eines verdrillten Endes (41, 42) des Verbindungsstücks (4) in einer Öffnung der Karte bestimmt ist.

2. Organ gemäß Anspruch 1, bei dem der genannte, zum Aufnehmen der einen der Karten bestimmte Abschnitt zum aufstützenden Aufnehmen der Karte bestimmte Verdickungen umfasst.

3. Organ gemäß Anspruch 1 oder 2, bei dem das genannte Verbindungsstück (4) eine Lamellenform aufweist.

4. Organ gemäß einem der voranstehenden Ansprüche, bei dem das Verbindungsstück (4) zwei Enden umfasst, wobei jedes Ende zum mechanischen Verbinden mit einer der zwei Karten bestimmt ist.

5. Organ gemäß einem der voranstehenden Ansprüche, bei dem das Verbindungsstück (4) zum mechanischen Verbinden mit einer der Karten per Löten bestimmt ist.

6. Organ gemäß einem der voranstehenden Ansprüche, bei dem der elektrische Stift (2) ein Ende aufweist, das einen flexiblen Fuß (21) umfasst, der zum Aufliegen gegen die Fläche einer der Karten bestimmt ist.

7. Organ gemäß einem der voranstehenden Ansprüche, bei dem das genannte Verbindungsstück (4) und der Stift (2) sich in Längsrichtung gemäß einer Richtung (Δ) erstrecken.

8. Organ gemäß Anspruch 7, bei dem der genannte Körper (6) zwei Teile (61, 62) umfasst, die sich hauptsächlich in einer Richtung erstrecken, die in der Längsrichtung (Δ) des Stifts (2) und des Verbindungsstücks (4) erstrecken, wobei die genannten Teile (61, 62) derart sind, dass:
- ein erster Teil (61) den Stift (2) und das Verbindungsstück (4) an einer ersten Region des Stifts (2) und des Verbindungsteils (4) hält;
- ein zweiter Teil (62) den Stift (2) und das Verbindungsstück (4) an einer zweiten Region des Stiftes (2) und des Verbindungsstücks (4) hält;
wobei die zwei Teile (61, 62) voneinander gemäß der Längsrichtung (Δ) des Stiftes (2) und des Verbindungsstücks (4) beabstandet sind.

9. Organ gemäß Anspruch 8, bei dem der Körper (6) wenigstens einen Längsteil (65) umfasst, der den ersten (61) und zweiten Teil (62) des Körpers (6) miteinander verbindet.

10. Elektronisches Modul (100), umfassend:
- zwei elektronische Karten (210, 220);
- ein elektrisches Verbindungsorgan (1) gemäß einem der voranstehenden Ansprüche, das gleichzeitig die zwei Karten (210, 220) elektrisch anschließt und mechanisch verbindet, wobei das Verbindungsstück (4) mechanisch mit wenigstens einer der Karten (210, 220) durch ein verdrilltes Ende (41, 42) in einer Öffnung (210a, 220a) der Karte (210, 220) derart verbunden ist, dass es gegen einen Rand der genannten Öffnung (210a, 220a) zum Eingreifen kommt.

11. Modul gemäß Anspruch 10, umfassend ein elektrisches Anschlussorgan (1) gemäß Anspruch 5, bei dem das Verbindungsstück (4) per Löten mechanisch mit einer der Karten (201, 220) verbunden ist:

12. Modul gemäß einem der Ansprüche 10 bis 11, bei dem eine erste Karte (210) auf einem Träger (150) ruht, wobei die mechanische Verbindung zwischen dem mechanischen Verbindungsstück (4) und der zweite Karte (220) ein Aufstützen der zweiten Karte (220) auf einem Abschnitt (150b) des genannten Trägers (150) umfasst.

13. Elektrisches Anschlussverfahren von zwei elektronischen Karten (210, 220) miteinander, umfassend die Schritte, bestehend aus:
- auf einer ersten Karte (210) positionieren eines elektrischen Anschlussorgans (1), umfassend wenigstens einen elektrischen Stift (2), der zum elektrischen Anschließen der zwei Karten miteinander bestimmt ist, eines mechanischen Verbindungsstücks (4) zum mechanischen Verbinden der zwei Karten miteinander, wobei das elektrische Verbindungsorgan (1) angeordnet ist, um gleichzeitig den elektrischen Anschluss durch den Stift (2) und die mechanische Verbindung durch das Verbindungsstück (4) der zwei Karten zu erlauben, wobei das elektrische Anschlussorgan (1) auch einen Körper (6) umfasst, der sowohl den genannten elektrischen Stift (2) als auch das genannte mechanische Stück (4) trägt, wobei der genannte Körper (6) einen Abschnitt, bezeichnet als Stützabschnitt, umfasst, der zum Aufnehmen einer der elektronischen Karten bestimmt ist, wobei der Stützabschnitt und das Verbindungsstück (4) derart angeordnet sind, dass die genannte elektronische Karte an Ort und Stelle festgehalten und dabei gleichzeitig zwischen dem Stützabschnitt und einem Punkt, durch den das mechanische Verbindungsstück (4) eingespannt ist, das fest mit der Karte verbunden ist, eingespannt ist, wobei das Verbindungsstück (4) dazu bestimmt ist, mechanisch mit wenigstens einer der Karten mittels eines verdrillten Endes (41, 42) des Verbindungsstücks (4) in einer Öffnung der Karte verbunden zu sein;
- montieren der zweiten Karte (220) auf dem elektrischen Organ (1), wobei der Stift (2) des elektrischen Organs einen elektrischen Anschluss zwischen der ersten (210) und der zweiten Karte (220) realisiert und das Verbindungsstück (4) des elektrischen Organs (1) gleichzeitig eine mechanische Verbindung zwischen den Karten (210, 220) realisiert.

## Claims

1. An electrical connection member (1) configured to electrically connect two electronic boards to each other, the connection member comprising:
- at least one electrical pin (2) configured to electrically connect both boards to each other,
- a mechanical bonding piece (4) for mechanically bonding both boards to each other, the electrical connection member (1) being arranged to enable simultaneously the electrical connection by the pin (2), and the mechanical bond by the bonding piece (4), of both boards,
- a body (6) which carries both said electrical pin (2) and said mechanical bonding piece (4), said body (6) comprising a portion, known as a bearing portion, configured to bearingly receive one of the electronic boards, the bearing portion and the bonding piece (4) being arranged so that said electronic board is held in place by being wedged between the bearing portion and a point by which the mechanical bonding piece (4) is integral with the board,
**characterised in that** the bonding piece (4) is configured to be mechanically bonded to at least one of the boards through a twisted end (41, 42) of the bonding piece (4) in an aperture of the board.

2. The member according to claim 1, wherein said portion configured to bearingly receive one of the boards comprises bulges configured to bearingly receive the board.

3. The member according to claim 1 or 2, wherein said bonding piece (4) has a blade shape.

4. The member according to one of the previous claims, wherein the bonding piece (4) comprises two ends, each end being configured to be mechanically bonded to one of both boards.

5. The member according to one of the previous claims, wherein the bonding piece (4) is configured to be mechanically bonded to one of the boards by soldering.

6. The member according to one of the previous claims, wherein the electrical pin (2) has an end including a flexible leg (21) configured to be against the surface of one of the boards.

7. The member according to one of the previous claims, wherein said bonding piece (4) and the pin (2) longitudinally extend along a direction (Δ).

8. The member according to claim 7, wherein said body (6) comprises two parts (61, 62) mainly extending in a direction which is transverse to the longitudinal direction (Δ) of the pin (2) and of the bonding piece (4), said parts (61, 62) being such that:
- a first part (61) holds the pin (2) and the bonding piece (4) at a first region of the pin (2) and of the bonding piece (4);
- a second part (62) holds the pin (2) and the bonding piece (4) at a second region of the pin (2) and of the bonding piece (4);
both parts (61, 62) being remote from each other along the longitudinal direction (Δ) of the pin (2) and of the bonding piece (4).

9. The member according to claim 8, wherein the body (6) comprises at least one longitudinal part (65) linking the first (61) and second (62) parts of the body (6).

10. An electronic module (100) comprising:
- two electronic boards (210, 220);
- an electrical connection member (1) according to one of the previous claims which simultaneously electrically connects and mechanically bonds both boards (210, 220), the bonding piece (4) being mechanically bonded to at least one of the boards (210, 220) by a twisted end (41, 42) in an aperture (210a, 220a) of the board (210, 220) so as to be in engagement against an edge of said aperture (210a, 220a).

11. The module according to claim 10, comprising an electrical connection member (1) according to claim 5, wherein the bonding piece (4) is mechanically bonded to one of the boards (210, 220) by a solder.

12. The module according to one of claims 10 to 11, wherein a first board (210) lies on a support (150), the mechanical bonding between the mechanical bonding piece (4) and the second board (220) comprising a bearing of the second board (220) on a portion (150b) of said support (150).

13. A method for electrically connecting two electronic boards (210, 220) to each other, comprising the steps consisting in:
- positioning, on a first board (210), an electrical connection member (1) comprising at least one electrical pin (2) configured to electrically connect both boards to each other, a mechanical bonding piece (4) to mechanically bond both boards to each other, the electrical connection member (1) being arranged to simultaneously enable the electrical connection, by the pin (2), and the mechanical bonding, by the bonding piece (4), of both boards, the electrical connection member (1) also comprising a body (6) which both carries said electrical pin (2) and said mechanical bonding piece (4), said body (6) comprising a portion, known as a bearing portion, configured to bearingly receive one of the electronic boards, the bearing portion and the bonding piece (4) being arranged so that said electronic board is held in place by being wedged between the bearing portion and a point by which the mechanical bonding piece (4) is integral with the board, the bonding piece (4) being configured to be mechanically bonded to at least one of the boards through a twisted end (41, 42) of the bonding piece (4) in an aperture of the board;
- mounting the second board (220) on the electrical member (1), the pin (2) of the electrical member performing an electrical connection between the first (210) and second (220) boards, and the bonding piece (4) of the electrical member (1) simultaneously performing a mechanical bonding between the boards (210, 220).
